# EUROPEAN PATENT SPECIFICATION

(11) **EP 3 553 129 B1**
(45) Date of publication and mention of the grant of the patent: **22.11.2023**
(21) Application number: 17879410.3
(22) Date of filing: 08.12.2017
(51) Int. Cl.: C08L 63/00, C08G 59/24, C08K 3/36, C08K 5/375, C08K 5/50, C08L 61/34, H01L 23/29, H01L 23/31, C08G 59/64, C08G 59/50, C08G 59/56, C08G 59/62, C08G 59/68, C08L 61/00

(54) **CURING RESIN COMPOSITION, CURED PRODUCT OF, AND CURING METHOD FOR, CURING RESIN COMPOSITION, AND SEMICONDUCTOR DEVICE**
HÄRTENDE HARZZUSAMMENSETZUNG, GEHÄRTETES PRODUKT AUS DER HÄRTBAREN HARZZUSAMMENSETZUNG UND HÄRTUNGSVERFAHREN FÜR DIE HÄRTBARE HARZZUSAMMENSETZUNG SOWIE HALBLEITERBAUELEMENT
COMPOSITION DE RÉSINE DE DURCISSEMENT, PRODUIT DURCI DE, ET PROCÉDÉ DE DURCISSEMENT DESTINÉ À, LA COMPOSITION DE RÉSINE DE DURCISSEMENT, ET DISPOSITIF SEMI-CONDUCTEUR

(30) Priority: 09.12.2016 JP 2016239894
(43) Date of publication of application: 16.10.2019
(73) Proprietor: ENEOS Corporation, Tokyo (JP)
(72) Inventor: NISHITANI, Yoshinori, Tokyo 100-8162 (JP); MINAMI, Masaki, Tokyo 100-8162 (JP)
(74) Representative: Carpmaels & Ransford LLP
(86) International application number: PCT/JP2017/044250
(87) International publication number: WO 2018/105743

(56) References cited:
- WO-A1-2016/074291
- JP-A- 2006 233 188
- JP-A- 2015 535 865
- JP-A- 2016 207 898
- JP-A- 2016 536 403
- US-A1- 2013 161 080
- US-A1- 2016 222 204

## Description

### FIELD OF ART

The present invention relates to a curable resin composition excellent in curing speed, a cured product obtained from the curable resin composition, and a method for hardening the curable resin composition. The present invention further relates to a semiconductor device using the curable resin composition as a sealant.

### BACKGROUND ART

Curable resins have been widely used for various purposes, e.g. in a semiconductor sealant, a fiberreinforced plastic, etc. A benzoxazine compound has been used as a component of the curable resin. The benzoxazine compound is a compound having a benzoxazine ring containing a benzene skeleton and an oxazine skeleton. A cured product (polymerization product) of the benzoxazine compound is referred to as a benzoxazine resin. The benzoxazine resin is excellent in various properties such as heat resistance and mechanical strength, and therefore has been used as a high-performance material for many purposes in various fields.

Patent Publication 1 discloses a novel benzoxazine compound having a particular structure and a method for producing the same. Patent Publication 1 describes that this benzoxazine compound has a high heat conductivity and can be used for producing a cured benzoxazine resin product having a high heat conductivity.

Patent Publication 2 discloses a heat-hardened polybenzoxazine resin having a main chain containing a particular benzoxazine ring structure, some or all of the reactive ends of the resin being protected. Patent Publication 2 describes that the heat-hardened polybenzoxazine resin exhibits an excellent storage stability when dissolved in a solvent. US2016/0222204A1 relates to a resin composition used for copper clad laminates and printed circuit boards. US2013/0161080A1 relates to halogen-free resin compositions which can be applied to copper clad laminates and printed circuit boards.

### CITATION LIST

Patent Publication 1: JP 2013-60407 A
Patent Publication 2: JP 2012-36318 A

### SUMMARY OF THE INVENTION

### PROBLEMS TO BE SOLVED BY THE INVENTION

However, in the fields of adhesive, sealant, paint, matrix resin for composite material, and the like, there has been a demand for a cured resin that has a higher heat resistance and a higher deformation resistance with a sufficient strength to meet severer conditions. Furthermore, in the fields of semiconductor device and the like, there has been a demand for a curable resin composition that has a rapid curing property and a high curing speed in addition to the above properties to improve the productivity. A curable resin composition capable of exhibiting a rapid curing property and forming a cured product with excellent properties has not been developed.

Accordingly, an object of the present invention is to provide a curable resin composition capable of having a rapid curing property and forming a cured product with a high heat resistance or the like, a cured product obtained from the curable resin composition, and a method for hardening the curable resin composition. Another object of the present invention is to provide a semiconductor device using the curable resin composition as a sealant.

### MEANS FOR SOLVING THE PROBLEM

As a result of intense research in view of the above objects, the inventors have developed a novel rapid-curable resin composition containing a polyfunctional benzoxazine compound, a polyfunctional epoxy compound, a curing agent, and a phosphorus-containing curing accelerator, and have found that a cured product obtained from the composition is excellent in heat resistance or the like. The present invention has been accomplished based on this finding.

The present invention is defined by the appended claims. According to an aspect of the present invention, there is provided a curable resin composition comprising (A) a polyfunctional benzoxazine compound having at least two benzoxazine rings, (B) a polyfunctional epoxy compound having at least one norbornane structure and at least two epoxy groups, (C) a curing agent, and (D) a phosphorus-containing curing accelerator. The polyfunctional epoxy compound (B) is an alicyclic compound. The polyfunctional benzoxazine compound of (A) is a first benzoxazine compound or a second benzoxazine compound. The first benzoxazine compound is a compound having at least two benzoxazine ring structures represented by the following formula (1), and the benzene rings in the two benzoxazine ring structures are bonded to each other. The second benzoxazine compound is represented by the following formula (2).

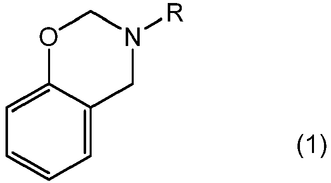

In the formula (1), R is an acyclic alkyl group having 1 to 12 carbon atoms, a cyclic alkyl group having 3 to 8 carbon atoms, or an aryl group having 6 to 14 carbon atoms, and the aryl group may have a substituent of a halogen atom or an acyclic alkyl group having 1 to 12 carbon atoms.

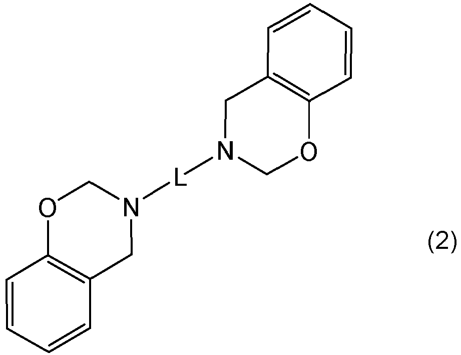

In the formula (2), L is a divalent organic group having 1 to 5 aromatic rings or an alkylene group having 2 to 10 carbon atoms.

The curable resin composition may further contain (E) an inorganic filler in addition to the components (A) to (D).

According to another aspect of the present invention, there is provided a cured product obtained by hardening the curable resin composition containing the components (A) to (D) or the components (A) to (E).

According to a further aspect of the present invention, there is provided a semiconductor device comprising a cured product obtained by hardening the curable resin composition containing the components (A) to (E) and a semiconductor element placed in the cured product.

According to a still further aspect of the present invention, there is provided a method for hardening the curable resin composition comprising the steps of: heating and mixing (A) the polyfunctional benzoxazine compound having at least two benzoxazine rings, (B) the polyfunctional epoxy compound having at least one norbornane structure and at least two epoxy groups, (C) the curing agent, (D) the phosphorus-containing curing accelerator, and (E) the inorganic filler in a mixing apparatus to obtain a mixture; processing the mixture into a powder, a pellet, or a granule of the curable resin composition; and heating the curable resin composition at a temperature of 180°C to 300°C for a period of 20 seconds to 1 hour to harden the curable resin composition.

### EFFECT OF THE INVENTION

The curable resin composition of the present invention, which contains the components (A) to (D) and may further contain the component (E) if desired, is a novel, rapid-curing-type, curable resin composition. The curable resin composition exhibits a high curing speed, and the cured product obtained therefrom has an excellent heat resistance, is not easily decomposed by heat, and has a high glass-transition temperature. Therefore, the curable resin composition of the present invention can be used for various products required to have a rapid curing property and a high heat resistance, such as adhesives, sealants, paints, and matrix resins for composite materials. In particular, when the curable resin composition is used for the sealant for the semiconductor element, the sealant has an excellent sealing property and can improve the productivity of the semiconductor device.

The hardening method of the present invention is capable of forming in a short time the cured product that has the above excellent properties and can be used in various fields.

### EMBODIMENTS OF THE INVENTION

The curable resin composition of the present invention contains (A) a polyfunctional benzoxazine compound having at least two benzoxazine rings, (B) a polyfunctional epoxy compound having at least one norbornane structure and at least two epoxy groups, (C) a curing agent, and (D) a phosphorus-containing curing accelerator. Hereinafter, the curable resin composition is referred to simply as the composition, and these components are referred to as the components (A) to (D). In the present invention, each of the components (A) and (B) may be a compound usable as a monomer, and some or all of molecules of the compound may be reacted to generate an oligomer. Thus, in the composition of the present invention, each of the components (A) and (B) may form a prepolymer, which is a precursor of a cured resin.

The component (A) is a first benzoxazine compound or a second benzoxazine compound. The composition of the present invention may contain a plurality of types of the first benzoxazine compounds, may contain a plurality of types of the second benzoxazine compounds, and may contain the first benzoxazine compound and the second benzoxazine compound, as the component (A). The composition may contain a benzoxazine compound different from the first and second benzoxazine compounds.

The first benzoxazine compound is a compound having at least two benzoxazine ring structures represented by the following formula (1).

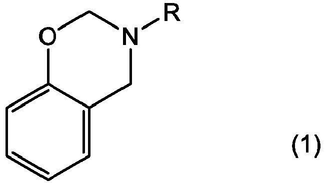

In the formula (1), R is an acyclic alkyl group having 1 to 12 carbon atoms, a cyclic alkyl group having 3 to 8 carbon atoms, or an aryl group having 6 to 14 carbon atoms. The aryl group may have a substituent of a halogen atom or an acyclic alkyl group having 1 to 12 carbon atoms. In the first benzoxazine compound, the benzene rings in the two benzoxazine ring structures of the formula (1) are bonded to each other. The benzene rings may be connected via a linking group, and may be directly connected with each other without the linking group. The benzene ring in the benzoxazine ring structure of the formula (1) may have a substituent.

The first benzoxazine compound has a plurality of the benzoxazine ring structures represented by the formula (1), and R's in the structures may be the same as or different from each other. The first benzoxazine compound may have another benzoxazine ring structure different from the benzoxazine ring structure represented by the formula (1). The composition of the present invention may contain as the component (A) a plurality of types of the first benzoxazine compounds having different R's, different linking groups, different bonding positions, or the like.

It is preferred that the first benzoxazine compound is a compound represented by the following formula (1a).

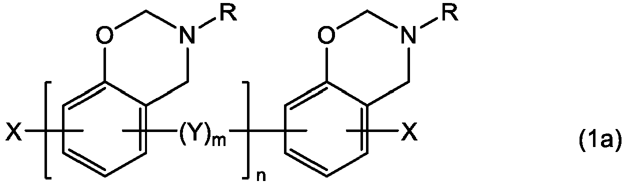

In the formula (1a), R is an acyclic alkyl group having 1 to 12 carbon atoms, a cyclic alkyl group having 3 to 8 carbon atoms, or an aryl group having 6 to 14 carbon atoms. The aryl group may have a substituent of a halogen atom or an acyclic alkyl group having 1 to 12 carbon atoms. A plurality of R's in the formula (1a) may be the same as or different from each other. X is a hydrogen atom or a hydrocarbon group having 1 to 6 carbon atoms. A plurality of X's in the formula (1a) may be the same as or different from each other. Y is an alkylene group having 1 to 6 carbon atoms, an oxygen atom, a sulfur atom, an SO₂ group, or a carbonyl group. m is 0 or 1, and n is an integer of 1 to 10. When m is 0, the benzene rings are directly connected with each other without the linking group.

When R in the formula (1) or (1a) is an acyclic alkyl group having 1 to 12 carbon atoms, specific examples of the acyclic alkyl groups include a methyl group, an ethyl group, a propyl group, an isopropyl group, an n-butyl group, an isobutyl group, and a t-butyl group. When R is a cyclic alkyl group having 3 to 8 carbon atoms, specific examples of the cyclic alkyl groups include a cyclopentyl group and a cyclohexyl group. When R is an aryl group having 6 to 14 carbon atoms, specific examples of the aryl groups include a phenyl group, a 1-naphthyl group, a 2-naphthyl group, a phenanthryl group, and a biphenyl group. When R is an aryl group having 6 to 14 carbon atoms and having a substituent of a halogen atom or an acyclic alkyl group having 1 to 12 carbon atoms, specific examples of the aryl groups include an o-tolyl group, an m-tolyl group, a p-tolyl group, a xylyl group, an o-ethylphenyl group, an m-ethylphenyl group, a p-ethylphenyl group, an o-t-butylphenyl group, an m-t-butylphenyl group, a p-t-butylphenyl group, an o-chlorophenyl group, and an o-bromophenyl group. It is preferred that R is selected from the group consisting of a methyl group, an ethyl group, a propyl group, a phenyl group, and an o-methylphenyl group, which are excellent in handling characteristics.

Specific examples of such first benzoxazine compounds include compounds of the following formula (1X) and oligomers prepared by polymerizing the compounds.

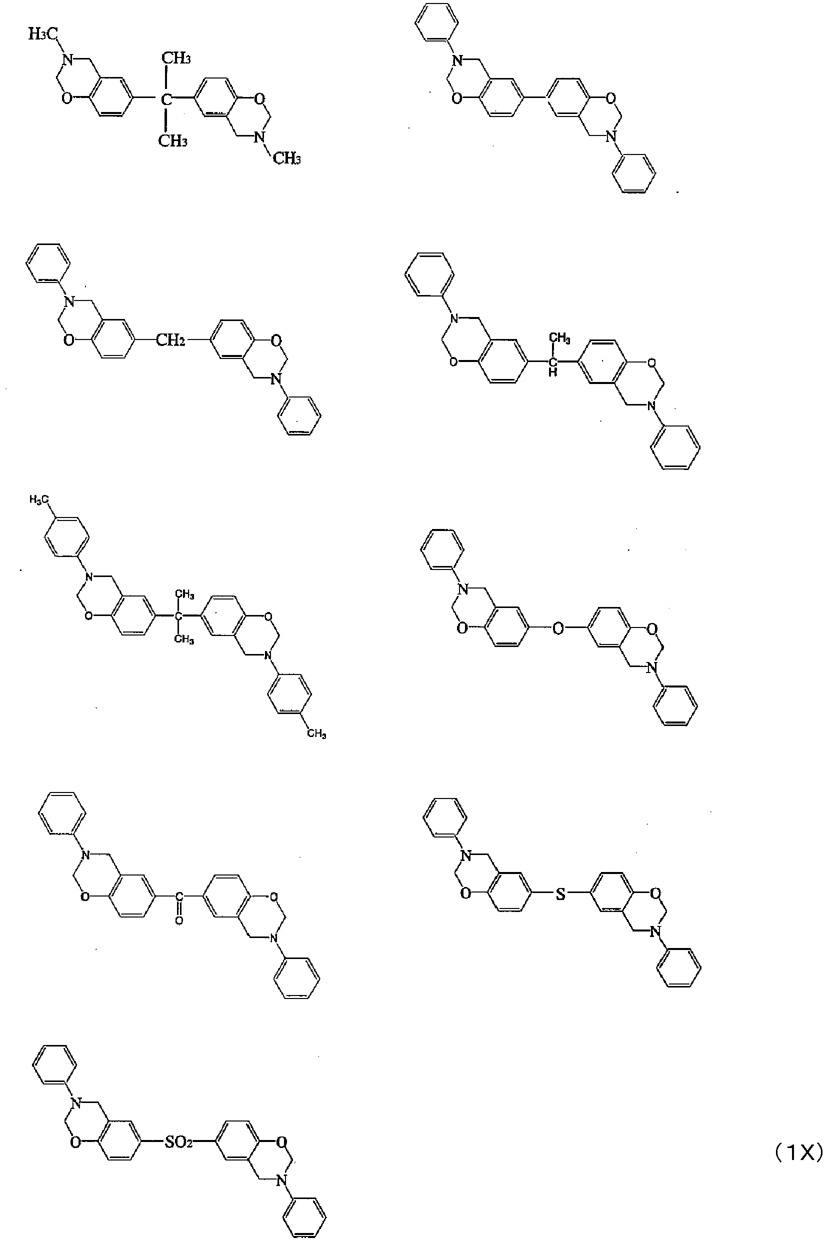

The second benzoxazine compound is a compound represented by the following formula (2). Thus, in the second benzoxazine compound, the N atoms in the two benzoxazine rings are connected with each other via a linking group L.

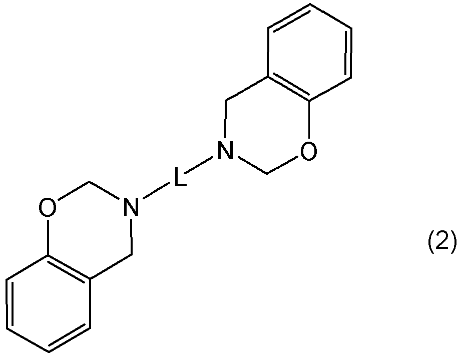

In the formula (2), L is a divalent organic group having 1 to 5 aromatic rings or an alkylene group having 2 to 10 carbon atoms. Each of the divalent organic group and the alkylene group may contain an oxygen atom and/or a sulfur atom. The composition of the present invention may contain as the component (A) a plurality of types of the second benzoxazine compounds represented by the formula (2) having different L's.

When L in the formula (2) is a divalent organic group having 1 to 5 aromatic rings, the divalent organic group may have a monocyclic structure, a polycyclic structure, a condensed ring structure, or the like. Specific examples of the organic groups include groups of the following formula (3).

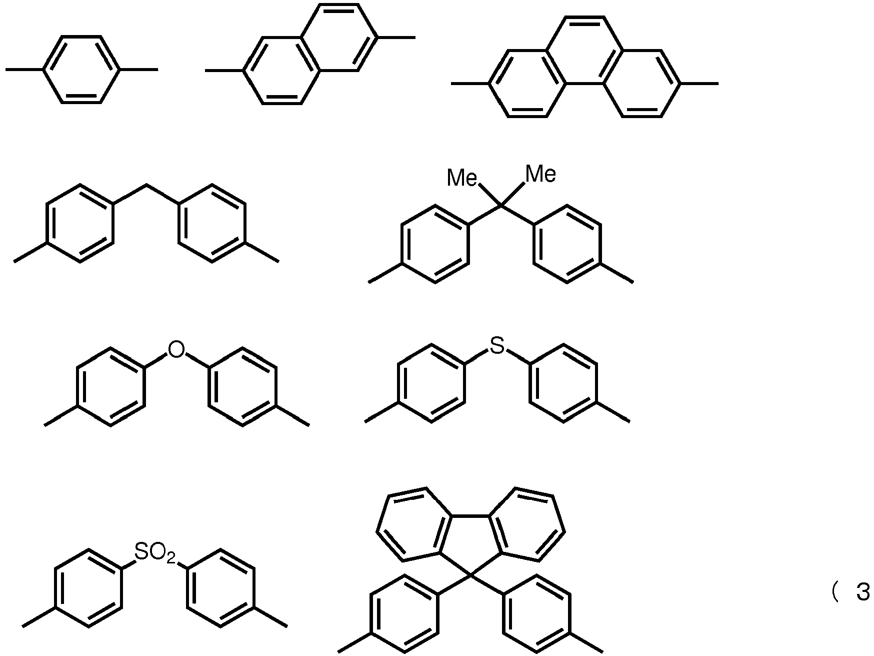

When L in the formula (2) is an alkylene group, the alkylene group has 2 to 10 carbon atoms, and preferably has 2 to 6 carbon atoms. Specific examples of the alkylene groups include a methylene group, an ethylene group, and an isopropylidene group. The alkylene group is preferably a methylene group.

Specific examples of such second benzoxazine compounds include compounds of the following formula (2X) and oligomers prepared by polymerizing the compounds.

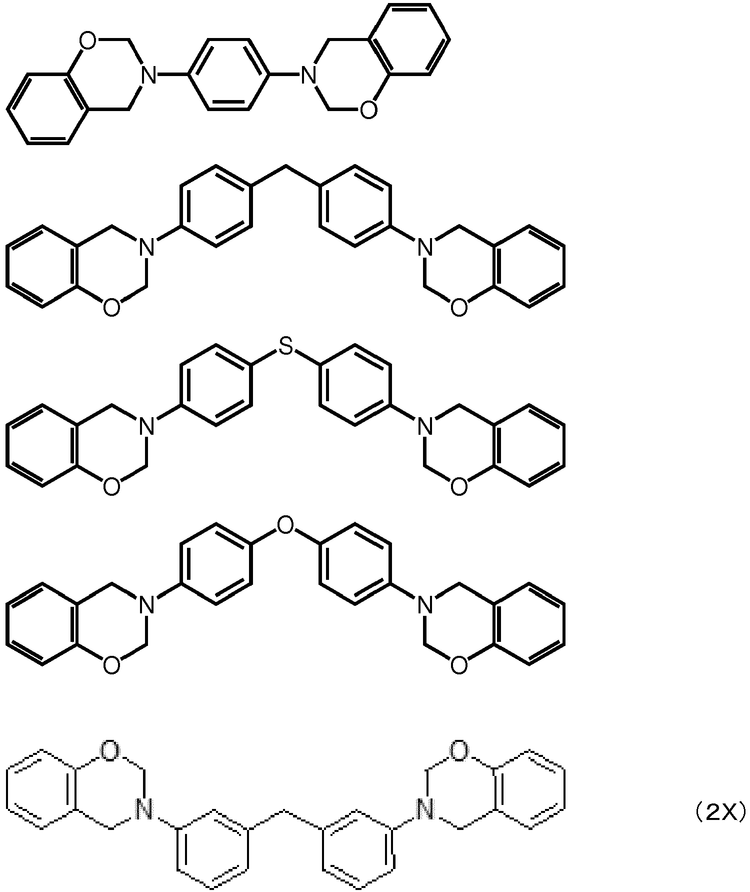

A commercially-available product may be used as the component (A). Examples of the commercially-available products include bisphenol F-aniline type (F-a type) benzoxazine compounds and phenol-diaminodiphenylmethane type (P-d type) benzoxazine compounds available from Shikoku Chemicals Corporation.

The component (B) is the polyfunctional epoxy compound having at least one norbornane structure and at least two epoxy groups (hereinafter referred to as the polyfunctional epoxy compound). The composition of the present invention may contain a plurality of types of the polyfunctional epoxy compounds as the component (B). The component (B) is a compound having a 5-membered ring structure, 6-membered ring structure, or norbornane ring structure having an epoxy group shown in the following formula (4).

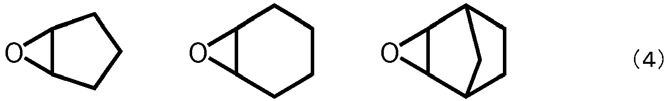

Specific examples of the components (B) include the compounds of the following formula (5).

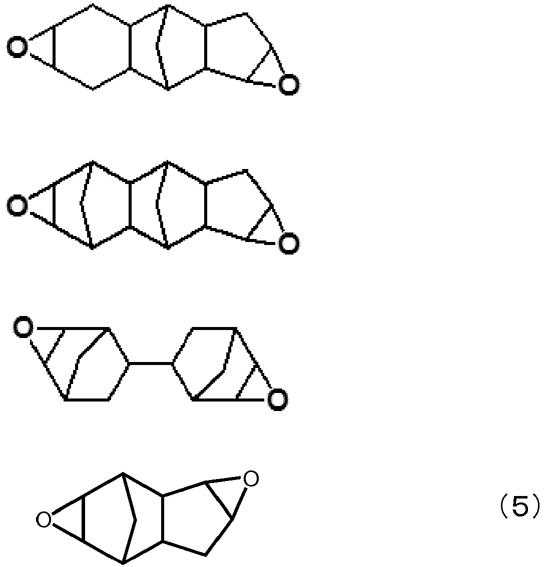

An example of production of the component (B) will be described below. For example, as shown in the following formula (6), the compound (5-1) can be produced by carrying out a reaction between the compound (a) and meta-chloroperbenzoic acid. The compound (a) can be synthesized by the Diels-Alder reaction between butadiene and dicyclopentadiene.

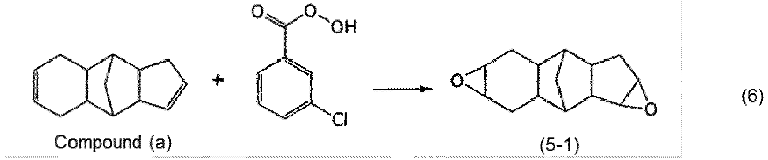

As shown in the following formula (7), the compound (5-2) can be produced by carrying out a reaction between the compound (b) (tricyclopentadiene) and meta-chloroperbenzoic acid. The compound (b) can be synthesized by the Diels-Alder reaction between cyclopentadiene and dicyclopentadiene.

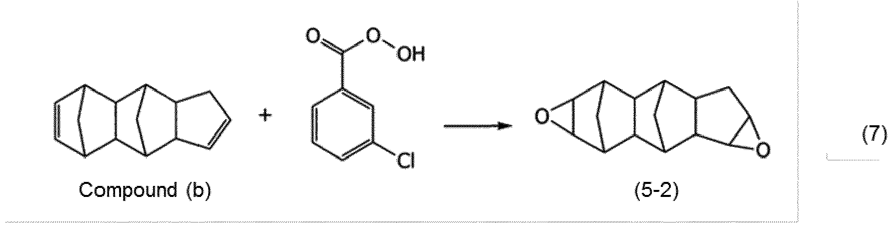

As shown in the following formula (8), the compound (5-3) can be produced by carrying out a reaction between the compound (c) and meta-chloroperbenzoic acid. The compound (c) can be synthesized by the Diels-Alder reaction between butadiene and cyclopentadiene.

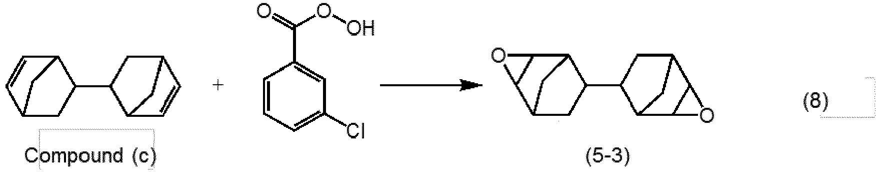

The compound (5-4) shown below can be produced by carrying out a reaction between dicyclopentadiene and potassium peroxymonosulfate (Oxone). The compound (5-4) is a dicyclopentadiene diepoxide, and is commercially available from Shandong Qihuan Biochemical Co., Ltd., etc. The commercially-available product can be used in the present invention.

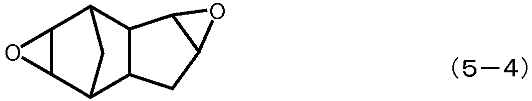

The content of the component (B) is preferably at least 5 parts by mass and at most 150 parts by mass, more preferably at least 10 parts by mass and at most 100 parts by mass, per 100 parts by mass of the component (A). The content of the component (B) within the preferred range can result in an excellent heat resistance. In a case where the composition of the present invention contains a plurality of types of the polyfunctional benzoxazine compounds as the component (A), the total content of these compounds is considered as 100 parts by mass. In a case where the composition of the present invention contains a plurality of types of the polyfunctional epoxy compounds as the component (B), the content of the component (B) is the total content of these compounds.

The component (C) is the curing agent. Examples of the components (C) include aromatic amine compounds (such as diethyltoluenediamine, metaphenylenediamine, diaminodiphenylmethane, diaminodiphenylsulfone, meta-xylenediamine, and derivatives thereof), aliphatic amines (such as triethylenetetramine and isophoronediamine), imidazole compounds (such as imidazole and imidazole derivatives), dicyandiamide, tetramethylguanidine, carboxylic acid anhydrides (such as methylhexahydrophthalic anhydride), carboxylic acid hydrazides (such as adipic acid hydrazide), carboxylic acid amides, monofunctional phenol compounds, polyfunctional phenol compounds (such as bisphenol A, bisphenol F, bisphenol sulfides, and polyphenol compounds), polymercaptan compounds, carboxylate salts, and Lewis acid complexes (such as boron trifluoride ethylamine complexes). These curing agents may be used alone or as a mixture of two or more. It is preferred that the composition of the present invention contains at least one selected from the group consisting of the imidazole compounds, the aromatic amine compounds, and the polyfunctional phenol compounds as the component (C).

The content of the component (C) is preferably at least 1 part by mass and at most 30 parts by mass per 100 parts by mass of the total of the components (A) and (B). When the content of the component (C) is within the preferred range, the hardening reaction of the composition can be carried out more efficiently, and the resultant cured product can exhibit a high heat resistance.

The component (D) is the curing accelerator containing phosphorus (hereinafter referred to also as the phosphorus-containing curing accelerator). The component (D) may be an organic phosphorus compound containing a covalently bonded phosphorus atom, a salt-type organic phosphorus compound containing a covalently or ionically bonded phosphorus atom, or the like, and is not limited thereto. One organic phosphorus compound may be used alone as the component (D), and two or more organic phosphorus compounds may be used in combination as the component (D). It is preferred that the composition contains, as the component (D), an organic phosphorus compound having a large effect of improving the curing speed, such as triphenylphosphine or tetraphenylphosphonium tetraphenylborate.

As described in JP 55-157594 A, the component (D) functions to accelerate a cross-linking reaction between an epoxy group and a phenolic hydroxyl group. The component (D) can function to accelerate also a reaction between an epoxy group and a hydroxyl group generated from the component (A) by a cleavage reaction at a high temperature. The component (D) is not particularly limited as long as it has the function.

The content of the component (D) is preferably at least 0.01 parts by mass and at most 10 parts by mass, more preferably at least 0.1 parts by mass and at most 7 parts by mass, per 100 parts by mass of the total of the components (A) and (B). When the content of the component (D) is within the preferred range, the composition can exhibit an excellent rapid curing property.

The composition of the present invention may further contain (E) an inorganic filler if desired. In the present invention, the inorganic filler is not particularly limited, and may be selected depending on a desired use or property of the composition or the cured product derived therefrom. Hereinafter, the inorganic filler is referred to as the component (E). It is preferred that the composition of the present invention contains the component (E) when it is used e.g. in a sealant for a semiconductor element or the like.

Examples of the components (E) include: oxides such as silica, alumina, titanium oxide, zirconium oxide, magnesium oxide, cerium oxide, yttrium oxide, calcium oxide, antimony trioxide, zinc oxide, and iron oxide; carbonates such as calcium carbonate, magnesium carbonate, barium carbonate, and strontium carbonate; sulfates such as barium sulfate, aluminum sulfate, and calcium sulfate; nitrides such as aluminum nitride, silicon nitride, titanium nitride, boron nitride, and manganese nitride; hydroxides such as calcium hydroxide, aluminum hydroxide, and magnesium hydroxide; silicon compounds such as calcium silicate, magnesium silicate, and aluminum silicate; boron compounds such as aluminum borate; zirconium compounds such as barium zirconate and calcium zirconate; phosphorus compounds such as zirconium phosphate and magnesium phosphate; titanium compounds such as strontium titanate, calcium titanate, magnesium titanate, bismuth titanate, barium titanate, and potassium titanate; minerals such as mica, talc, kaolin, kaolin clay, kaolinite, halloysite, cordierite, pyrophyllite, montmorillonite, sericite, amesite, bentonite, asbestos, wollastonite, sepiolite, zonolite, zeolite, hydrotalcite, hydrated gypsum, alum, diatomite, and boehmite; fly ash, dewatered sludge, glass bead, glass fiber, quartz sand, magnesium oxysulfate, silicon oxide, silicon carbide, and the like; metals such as copper, iron, cobalt, and nickel; alloys containing any of the metals; magnetic materials such as sendust, alnico magnet, and ferrite; and graphite, coke, carbon black, and the like. The component (E) is preferably a silica or an alumina. For example, the silica may be a molten silica, a spherical silica, a crystalline silica, an amorphous silica, a synthetic silica, a hollow silica, or the like, and is preferably a spherical silica or a crystalline silica. These substances for the component (E) may be used alone or in combination of two or more.

The component (E) may have a granular shape. In this case, the average grain diameter of the component (E) may be at least 0.01 µm and at most 150 µm, is preferably at least 0.1 µm and at most 120 µm, and is more preferably at least 0.5 µm and at most 75 µm, although not particularly limited. For example, in a case where the composition of the present invention is used in the sealant for the semiconductor element, when the average grain diameter is within the above range, filling of a mold cavity with the composition is improved. The average grain diameter of the component (E) may be measured by a laser diffraction scattering method. Specifically, the grain size distribution of the inorganic filler may be obtained based on the volume by using a laser diffraction-type grain size distribution measuring apparatus, and the median diameter may be used as the average grain diameter. The inorganic filler may be dispersed in water by ultrasonic wave, and the dispersion may be appropriately used as a sample for the measurement. LA-500, LA-750, LA-950, LA-960, and the like available from Horiba, Ltd. may be used as the laser diffraction-type grain size distribution measuring apparatus.

The amount of the component (E) is not particularly limited as long as the composition can maintain a sufficient rapid curing property and the resultant cured product can exhibit a high heat resistance. For example, in a case where the composition is used for a semiconductor sealant, the content of the component (E) may be 60% by mass or more, is preferably 80% by mass or more, and is more preferably 83% by mass or more, with respect to the total mass of the composition. Furthermore, the content of the component (E) may be 93% by mass or less, is preferably 92% by mass or less, and is more preferably 90% by mass or less. When the content of the component (E) is 80% by mass or more, moisture absorption increase and strength decrease can be suppressed in the process of hardening the composition, so that the resultant cured product can exhibit an excellent solder crack resistance. When the content of the component (E) is 93% by mass or less, the composition has a good flowability and can be easily introduced into a mold, and the cured product can exhibit an excellent sealing property. The semiconductor device of the present invention contains a semiconductor element and a cured product obtained by hardening the composition of the present invention containing the components (A) to (E). The semiconductor element is placed in the cured product. The term "the semiconductor element is placed in the cured product" means that the semiconductor element is sealed by the cured product, and thus that the semiconductor element is covered with the cured product. The entire semiconductor element may be covered with the cured product, and only a surface of the semiconductor element disposed on a base may be covered with the cured product.

The composition of the present invention may contain a benzoxazine compound different from the component (A) as long as the advantageous effects of the present invention are not deteriorated. A monofunctional benzoxazine compound having one benzoxazine ring may be added to the composition to lower the viscosity of the composition.

The composition of the present invention may contain a nanocarbon material, a flame retardant, a mold release agent, or the like, as long as the properties of the composition are not deteriorated.

Examples of the nanocarbon materials include carbon nanotubes, fullerenes, and derivatives thereof.

Examples of the flame retardants include red phosphorus, phosphoric acid esters (such as triphenyl phosphate, tricresyl phosphate, trixylenyl phosphate, cresyl diphenyl phosphate, xylenyl diphenyl phosphate, resorcinol bisphenyl phosphate, and bisphenol A bisdiphenyl phosphate), and boric acid esters.

Examples of the mold release agents include silicone oils, stearic acid esters, and carnauba waxes.

In a case where the composition of the present invention is hardened to prepare a molded film product as the cured product, a solvent may be added to the composition to control the viscosity of the composition within a range suitable for forming a thin film. The solvent is not particularly limited as long as the components (A) to (D) can be dissolved therein. Examples of the solvents include hydrocarbons, ethers, esters, and halogen-containing solvents. In a case where the composition contains the solvent, the cured product can be prepared by the steps of applying a solution of the composition to a base or the like, vaporizing the solvent, and subjecting the residue to heat hardening.

In the composition of the present invention, the mass ratio of the component (A) to all the components other than the solvent and the component (E) may be at least 10% by mass and at most 95% by mass, and is preferably at least 20% by mass and at most 80% by mass, more preferably at least 30% by mass and at most 65% by mass, further preferably at least 35% by mass and at most 55% by mass, particularly preferably at least 40% by mass and at most 55% by mass, in view of moldability, hardening property, workability, and the like. In general, the solvent is removed in the process of hardening the composition to prepare the cured product. Therefore, the properties of the cured product are hardly affected by the mass ratio of the solvent in the composition.

In a case where the composition of the present invention is used for the semiconductor sealant, one or more selected from colorants (e.g., carbon black, colcothar, titanium oxide); mold release agents such as natural waxes (e.g., carnauba wax), synthetic waxes (e.g., polyethylene oxide wax), higher fatty acids (e.g., stearic acid), metal salts (e.g., zinc stearate), and paraffins; low-stress additives (e.g., silicone oil, silicone rubber); metal hydroxides (e.g., aluminum hydroxide, magnesium hydroxide); and flame retardants (e.g., phosphazene) may be appropriately added to the composition as long as the properties of the composition are not deteriorated. As described above, the carbon black, titanium oxide, aluminum hydroxide, magnesium hydroxide, and the like can act also as the component (E). The mass ratio of the components other than the components (A) to (E) to the total of all the components in the composition (other than the solvent) is generally 2% by mass or less, preferably 1% by mass or less.

The composition of the present invention can be produced by kneading or mixing the components (A) to (D), and optionally the component (E), the other additive, and the solvent, in an appropriate apparatus.

A method for the kneading or mixing is not particularly limited, and examples thereof include methods using an apparatus such as a kneader, planetary mixer, twin-screw extruder, or hot roll. For example, in a case where the components (A) and (B) are in a high-viscosity liquid or solid state at room temperature or where the component (E) is used, the components may be kneaded under a heat condition, pressurized condition, or reduced pressure condition, as necessary. The heating is preferably carried out at a temperature of 80°C to 120°C.

In a case where the composition contains the component (E), the composition may be in a solid state at room temperature. Therefore, in this case, the composition may be cooled and pulverized into a powder after the heat kneading. The powder may be tableted into a pellet form, or alternatively may be granulated into a granule form.

In a case where the composition of the present invention does not contain the component (E) and is used for preparing an FRP prepreg or the like, the viscosity of the composition at 50°C is preferably 10 to 3,000 Pa·s, more preferably 10 to 2,500 Pa·s, most preferably 100 to 2,000 Pa·s. In a case where the composition is used for forming a sealant or a coating, the viscosity of the composition is not particularly limited as long as the sealing or coating process can be carried out without trouble.

In a case where an electronic part such as the semiconductor element or the like is sealed by the composition of the present invention to produce the semiconductor device or the like, a conventional forming method such as a transfer molding method, a compression molding method, or an injection molding method may be used in the sealing process.

The composition of the present invention can be hardened (cured) by carrying out a ring-opening polymerization reaction under the same conditions as those for a known benzoxazine compound and/or a known epoxy compound.

For example, the cured product of the present invention can be produced by the following method. First, the composition of the present invention is produced by the above method. The cured product can be produced by heating the curable resin composition at a temperature of 180°C to 300°C for a period of 20 seconds to 1 hour. The cured product can be continuously produced by conducting the hardening for a period of 20 to 180 seconds. It is preferred from the viewpoint of achieving a sufficient strength that the heating is conducted for a period of about 5 minutes to 1 hour.

A benzoxazine compound and/or an epoxy compound other than the components (A) and (B) may be added to the composition to obtain the cured product as long as the advantageous effects of the present invention are not deteriorated.

The composition of the present invention exhibits a high curing speed, and the cured product obtained therefrom has an excellent heat resistance, is not easily decomposed by heat, and has a high glass-transition temperature. The composition of the present invention seems to be useful for producing such excellent cured product for the following reasons. When a benzoxazine compound is homopolymerized, phenolic hydroxyl groups are generated. The phenolic hydroxyl groups may undergo keto-enol tautomerization at a high temperature (e.g. 200°C or higher), whereby the polymer chain may be cleaved, resulting in a low heat resistance and a low glass-transition temperature. In the present invention, the component (B) is hardly homopolymerized, and is reacted with phenolic hydroxyl groups derived from the benzoxazine rings, so that the cleavage of the polymer chain can be prevented. Consequently, the resultant cured product has the high heat resistance.

In addition, the component (D) acts together with the component (C) to accelerate the hardening reaction of the composite resin containing the components (A) and (B). Therefore, the composition of the present invention can exhibit the rapid curing property.

### Examples

The present invention will be described more specifically below with reference to Examples and Comparative Examples without intention of restricting the scope of the invention.

### <Component (A); Polyfunctional benzoxazine compound>

The following compounds (A1) and (A2) were each used as the component (A).
(A1); Bisphenol F-aniline type (F-a type) benzoxazine compound of the following formula (1-1) available from Shikoku Chemicals Corporation. 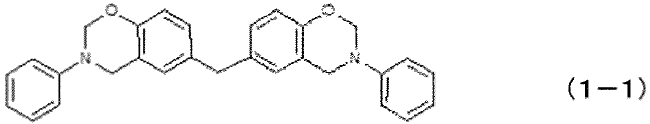
(A2); Phenol-diaminodiphenylmethane type (P-d type) benzoxazine compound of the following formula (2-1) available from Shikoku Chemicals Corporation.

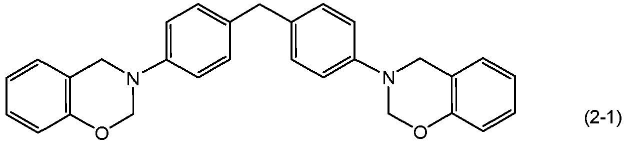

### <Component (B) or (BC); Polyfunctional epoxy compound>

The following compounds (B1) to (B3) were each used as the component (B).

### (B1); Compound (5-1)

The compound (a) shown in the above formula (6) was synthesized by a method described in Shoichi Tsuchida, et. al., "Diels-Alder Reaction between Butadiene and Cyclopentadiene, Determination of Trimers", Journal of The Japan Petroleum Institute, 1972, Volume 15, Issue 3, Pages 189-192. 15.9 L of chloroform and 1.6 kg of the compound (a) were introduced into a reaction vessel, and 4.5 kg of meta-chloroperbenzoic acid was added dropwise thereto while stirring at 0°C. The obtained mixture was heated to the room temperature, and the reaction shown in the formula (6) was carried out for 12 hours. A by-product of meta-chlorobenzoic acid was removed from the resultant mixture by filtration.

The filtrate was washed with a 1-N aqueous sodium hydroxide solution three times, and was further washed with a saturated sodium chloride solution.

The organic layer was dried over magnesium sulfate, the magnesium sulfate was removed by filtration, and the filtrate was concentrated to obtain a crude product. 2 kg of toluene was added to the crude product, and the crude product was dissolved at the room temperature. 6 kg of heptane was added dropwise to the solution to conduct crystallization, and the resultant was aged at 5°C for 1 hour. The crystallized product was isolated by filtration, washed with hexane, and dried under a reduced pressure at 35°C for 24 hours, to obtain 1.4 kg of a white solid of the following compound (5-1).

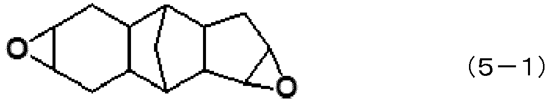

### (B2); Compound (5-2) (tricyclopentadiene diepoxide)

The compound (b) shown in the above formula (7) was synthesized in the same manner as the compound (a) by a method described in the above reference. 59.2 kg of chloroform and 4.0 kg of the compound (b) were introduced into a reaction vessel, and 10.6 kg of meta-chloroperbenzoic acid was added dropwise thereto while stirring at -10°C. The obtained mixture was heated to the room temperature, and the reaction shown in the formula (7) was carried out for 12 hours. A by-product of meta-chlorobenzoic acid was removed from the resultant mixture by filtration. The filtrate was washed with 42.0 kg of a 5% aqueous sodium sulfite solution. The organic layer was washed with 41.6 kg of a 1-N aqueous sodium hydroxide solution four times, and further washed with 48.0 kg of a saturated sodium chloride solution. The organic layer was dried over magnesium sulfate, the magnesium sulfate was removed by filtration, and the filtrate was concentrated to obtain 5.1 kg of a crude product. 3.5 kg of toluene was added to the crude product, and the crude product was dissolved at the room temperature. 13.7 kg of heptane was added dropwise to the solution to conduct crystallization, and the resultant was aged at 5°C for 1 hour. The crystallized product was isolated by filtration, washed with heptane, and dried under a reduced pressure at 35°C for 12 hours, to obtain 2.8 kg of a white solid of the following compound (5-2).

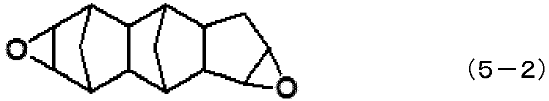

### (B3); Compound (5-4) (dicyclopentadiene diepoxide)

10 kg of dicyclopentadiene, 68 kg of sodium bicarbonate, 100 L of acetone, and 130 L of an ion-exchange water were introduced into a reaction vessel, and the resultant reaction liquid was cooled to a temperature of 10°C or lower. 84 kg of Oxone was added slowly to the reaction liquid while cooling to maintain the reaction liquid at a temperature of 30°C or lower, and the reaction liquid was stirred to carry out a reaction for 10 hours. Extraction with 100 L of ethyl acetate was carried out two times, and the organic layer was collected. Then, the organic layer was washed with 100 L of a mixed aqueous solution (containing 20% by weight of sodium chloride and 20% by weight of sodium thiosulfate), and was further washed with 100 L of an ion-exchange water two times. The washed organic layer was dried over magnesium sulfate, the magnesium sulfate was removed by filtration, and organic solvents were distilled away from the filtrate, to obtain 11 kg of a white solid of the following compound (5-4).

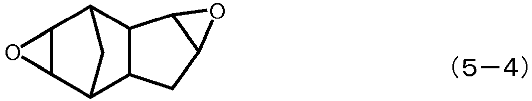

The following two components (BC1) and (BC2), which had no norbornane structures, were each used as (BC) a polyfunctional epoxy compound for Comparative Examples.
(BC1); Polyfunctional epoxy compound of the following formula (9), YX-4000H available from Mitsubishi Chemical Corporation. 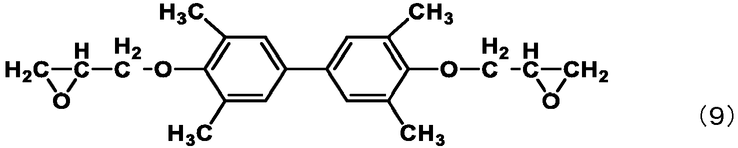
(BC2); Polyfunctional epoxy compound of the following formula (10), NC3000 available from Nippon Kayaku Co., Ltd.

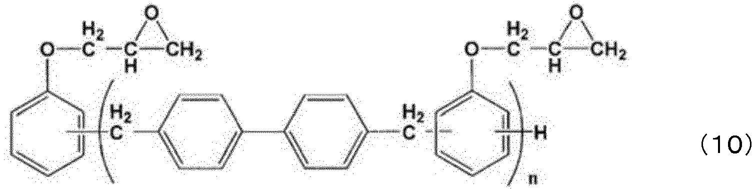

### <Component (C); Curing agent>

The following compounds (C1) to (C3) were each used as the component (C).
(C1); Bis(4-hydroxyphenyl) sulfide of the following formula (11), TDP available from Tokyo Chemical Industry Co., Ltd. 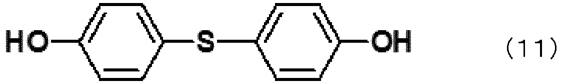
(C2); 4,4'-Diaminodiphenyl sulfide of the following formula (12), DDS available from Tokyo Chemical Industry Co., Ltd. 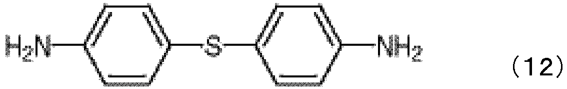
(C3); Bisphenol F of the following formula (13), BisF available from Honshu Chemical Industry Co., Ltd.

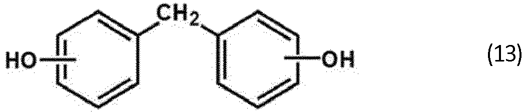

### <Component (D); Phosphorus-containing curing accelerator>

The following compounds (D1) to (D3) were each used as the component (D).
(D1); Triphenylphosphine TPP available from Hokko Chemical Industry Co., Ltd.
(D2); Tetraphenylphosphonium tetraphenylborate TPP-K available from Hokko Chemical Industry Co., Ltd.
(D3); Tetraphenylphosphonium tetra-p-tolyl borate TPP-MK available from Hokko Chemical Industry Co., Ltd.

### <Component (E); Inorganic filler>

A molten spherical silica having an average grain diameter D50 of 22 µm, FB-820 available from Denka Company Limited, was used as the component (E). This is hereinafter referred to as (E).

### <Other components>

A carnauba wax available from Clariant Japan K.K. was used as a mold release agent, and a carbon black MA600 available from Mitsubishi Chemical Corporation was used as a colorant. Although the carbon black was used as a colorant, it acted also as the component (E).

### (Example 1)

A composition and a cured product of Example 1 were prepared, the gel time was measured to evaluate the curing speed, and the glass-transition temperature was measured to evaluate the heat resistance, as described below.

The components (A1), (B1), (C1), (D1), and (E), the carnauba wax, and the carbon black were kneaded at the mixing ratios shown in Table 1 under the atmospheric pressure for 10 minutes by using a hot roll kneader having two rolls having surface temperatures of 90°C and 100°C, and then were cooled to the room temperature to obtain a mixture. The mixture was pulverized into a powder by Mini Speed Mill MS-09 available from Labonect K.K. to obtain the composition, so that the composition could be easily introduced into a mold.

### <Gel time>

The hardening (curing) property of the composition of the present invention can be evaluated based on the measurement of the gel time. The gel time is not particularly limited, and is preferably at least 20 seconds and at most 120 seconds, more preferably at least 30 seconds and at most 100 seconds. In Examples, according to Gel Time Method B (plate method) of JIS K 6910 (2007), a composition was placed on a hot plate having a controlled temperature of 200°C, the composition was stirred by a spatula, and the time (second) elapsed until the composition lost its flowability (until it became impossible to stir the composition due to progress of the thermal hardening reaction) was measured as the gel time. When the composition exhibits a shorter gel time, the composition has a higher curing speed and a more excellent rapid curing property. The results are shown in Table 1.

### <Glass-transition temperature; Tg>

The heat resistance of the cured product of the present invention can be evaluated based on the measurement of the glass-transition temperature. The glass-transition temperature is not particularly limited as long as the advantageous effects of the present invention are achieved. The glass-transition temperature is preferably 200°C or higher, more preferably 210°C or higher, further preferably 220°C or higher. The glass-transition temperature can be measured by differential scanning calorimetry (DSC). The glass-transition temperature can be easily measured by using a commercially-available differential scanning calorimeter (e.g., available from Hitachi High-Tech Science Corporation). In Examples, a prepared composition was hardened in a transfer molding apparatus under conditions of a mold temperature of 200°C, an injection pressure of 4 MPa, and a hardening time of 6 minutes, and was further heated at 240°C for 4 hours in an oven in a posthardening treatment, to prepare a cured product having a height of 3 mm, a width of 3 mm, and a length of 15 mm. The cured product was cut into a shape having a height of 3 mm, a width of 3 mm, and a length of 2 mm to obtain a test sample. The Tg of the test sample was measured by the DSC under the following conditions. The results are shown in Table 1.
Apparatus: X-DSC-7000 (available from Hitachi High-Tech Science Corporation)
Measurement conditions: N₂ flow rate of 20 mL/minute and heating rate of 20°C/minute

### (Examples 2 to 8)

Compositions of Examples 2 to 8 were produced in the same manner as Example 1 except that the mass ratios of the components were changed as shown in Table 1 respectively. The gel time and Tg of each composition were measured in the same manner as Example 1. The results are shown in Table 1.

### (Comparative Examples 1 to 4)

Compositions of Comparative Examples 1 to 4 were produced in the same manner as Example 1 except that the mass ratios of the components were changed as shown in Table 2 respectively. The gel time and Tg of each composition were measured in the same manner as Example 1. The results are shown in Table 2.

**Table 1**

| | | | Examples | | | | | | | |
|---|---|---|---|---|---|---|---|---|---|---|
| | | | 1 | 2 | 3 | 4 | 5 | 6 | 7 | 8 |
| Component [parts by mass] | Polyfunctional benzoxazine compound | (A1) | 7.5 | - | - | - | - | - | - | - |
| | | (A2) | - | 7.5 | 7.5 | 7.5 | 7.5 | 7.5 | 7.5 | 7.5 |
| | Polyfunctional epoxy compound | (B1) | 4.3 | 4.3 | 4.3 | 4.3 | 4.3 | 4.3 | - | - |
| | | (B2) | | | | | | | 4.3 | - |
| | | (B3) | - | - | - | - | - | - | | 4.3 |
| | Curing agent | (C1) | 2.1 | 2.1 | 2.1 | 2.1 | - | - | 2.1 | 2.1 |
| | | (C2) | - | - | - | - | 2.1 | - | - | - |
| | | (C3) | - | - | - | - | - | 2.1 | - | - |
| | Phosphorus-containing curing accelerator | (D1) | 0.5 | 0.5 | - | - | 0.5 | 0.5 | 0.5 | 0.5 |
| | | (D2) | - | - | 0.5 | - | - | - | - | - |
| | | (D3) | - | - | - | 0.5 | - | - | - | - |
| | Inorganic filler | (E) | 85 | 85 | 85 | 85 | 85 | 85 | 85 | 85 |
| | Carnauba wax (mold release agent) | | 0.3 | 0.3 | 0.3 | 0.3 | 0.3 | 0.3 | 0.3 | 0.3 |
| | Carbon black (colorant) | | 0.3 | 0.3 | 0.3 | 0.3 | 0.3 | 0.3 | 0.3 | 0.3 |
| Property evaluation | Gel time [seconds] | | 63 | 46 | 49 | 47 | 73 | 53 | 50 | 49 |
| | Tg [°C] | | 233 | 257 | 261 | 260 | 235 | 251 | 248 | 223 |

**Table 2**

| | | | Comparative Examples | | | |
|---|---|---|---|---|---|---|
| | | | 1 | 2 | 3 | 4 |
| Component [parts by mass] | Polyfunctional benzoxazine compound | (A1) | - | - | - | - |
| | | (A2) | 7.7 | 7.5 | 7.5 | 8.8 |
| | Polyfunctional epoxy compound | (B1) | 4.5 | - | - | 5.1 |
| | | (BC1) | | 4.3 | - | |
| | | (BC2) | - | | 4.3 | - |
| | Curing agent | (C1) | 2.1 | 2.1 | 2.1 | - |
| | | (C2) | - | - | - | - |
| | | (C3) | - | - | - | - |
| | Phosphorus-containing curing accelerator | (D1) | - | 0.5 | 0.5 | 0.5 |
| | | (D2) | - | - | - | - |
| | | (D3) | - | - | - | - |
| | Inorganic filler | (E) | 85 | 85 | 85 | 85 |
| | Carnauba wax (mold release agent) | | 0.3 | 0.3 | 0.3 | 0.3 |
| | Carbon black (colorant) | | 0.3 | 0.3 | 0.3 | 0.3 |
| Property evaluation | Gel time [seconds] | | 145 | 55 | 54 | 112 |
| | Tg [°C] | | 243 | 158 | 153 | 214 |

In Examples, the curable resin compositions exhibited gel times of 100 seconds or less, and the cured products had Tg's of 200°C or higher. Thus, in Examples, both of the excellent rapid curing property and the high heat resistance were achieved. In contrast, in Comparative Examples 1 and 4, although the cured products had relatively good heat resistances, the compositions exhibited long gel times and low curing speeds. Furthermore, in Comparative Examples 2 and 3, although the compositions exhibited relatively good rapid curing properties, the cured products had low Tg and low heat resistances. It is clear from the results that the curable resin composition according to an embodiment of the present invention is capable of achieving both of the excellent rapid curing property and the high heat resistance.

## Claims

1. A curable resin composition comprising (A) a polyfunctional benzoxazine compound having at least two benzoxazine rings, (B) a polyfunctional epoxy compound having at least one norbornane structure and at least two epoxy groups, (C) a curing agent, and (D) a phosphorus-containing curing accelerator,
wherein the polyfunctional benzoxazine compound of (A) is a first benzoxazine compound or a second benzoxazine compound,
the first benzoxazine compound is a compound having at least two benzoxazine ring structures represented by the following formula (1): 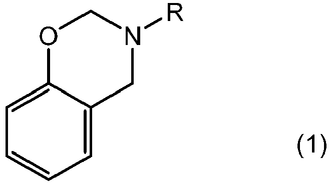 wherein R is an acyclic alkyl group having 1 to 12 carbon atoms, a cyclic alkyl group having 3 to 8 carbon atoms, or an aryl group having 6 to 14 carbon atoms, and the aryl group may have a substituent of a halogen atom or an acyclic alkyl group having 1 to 12 carbon atoms, the benzene rings in the two benzoxazine ring structures being bonded to each other, and
the second benzoxazine compound is represented by the following formula (2): 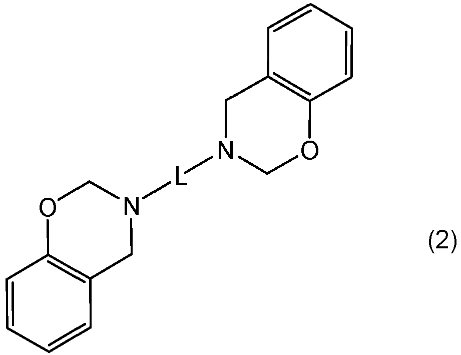 wherein L is a divalent organic group having 1 to 5 aromatic rings or an alkylene group having 2 to 10 carbon atoms, wherein the polyfunctional epoxy compound (B) is a compound having a 5-membered ring structure, 6-membered ring structure, or norbornane ring structure having an epoxy group shown in the following formulae:

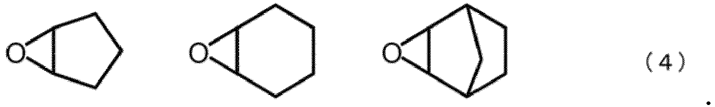

2. The curable resin composition according to claim 1, wherein the polyfunctional epoxy compound (B) is selected from the compounds of the following formulae:

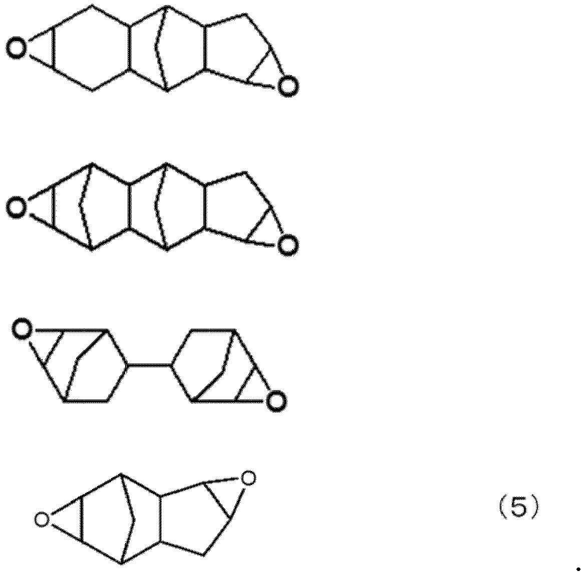

3. The curable resin composition according to any one of claims 1 to 2, further comprising (E) an inorganic filler.

4. The curable resin composition according to any one of claims 1 to 3, wherein the curing agent of (C) is at least one selected from the group consisting of imidazole compounds, aromatic amine compounds, and polyfunctional phenol compounds.

5. A cured product obtained by hardening the curable resin composition according to any one of claims 1 to 4.

6. A semiconductor device comprising a cured product obtained by hardening the curable resin composition according to claim 3 and a semiconductor element placed in the cured product.

7. A method for hardening a curable resin composition comprising the steps of:
heating and mixing (A) a polyfunctional benzoxazine compound having at least two benzoxazine rings, (B) a polyfunctional epoxy compound having at least one norbornane structure and at least two epoxy groups, (C) a curing agent, (D) a phosphorus-containing curing accelerator, and (E) an inorganic filler in a mixing apparatus to obtain a mixture;
processing the mixture into a powder, a pellet, or a granule of a curable resin composition; and
heating the curable resin composition at a temperature of 180°C to 300°C for a period of 20 seconds to 1 hour to harden the curable resin composition,
wherein the polyfunctional benzoxazine compound of (A) is a first benzoxazine compound or a second benzoxazine compound,
the first benzoxazine compound is a compound having at least two benzoxazine ring structures represented by the following formula (1): 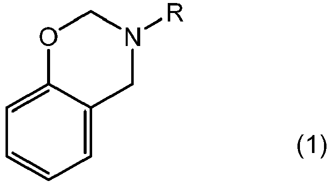 wherein R is an acyclic alkyl group having 1 to 12 carbon atoms, a cyclic alkyl group having 3 to 8 carbon atoms, or an aryl group having 6 to 14 carbon atoms, and the aryl group may have a substituent of a halogen atom or an acyclic alkyl group having 1 to 12 carbon atoms, the benzene rings in the two benzoxazine ring structures being bonded to each other, and
the second benzoxazine compound is represented by the following formula (2): 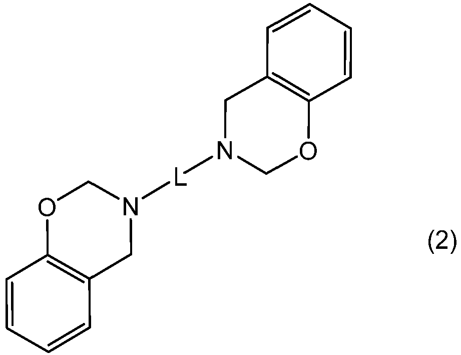 wherein L is a divalent organic group having 1 to 5 aromatic rings or an alkylene group having 2 to 10 carbon atoms, wherein the polyfunctional epoxy compound (B) is a compound having a 5-membered ring structure, 6-membered ring structure, or norbornane ring structure having an epoxy group shown in the following formulae:

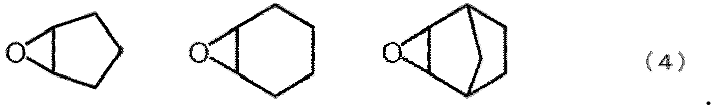

## Patentansprüche

1. Härtbare Harzzusammensetzung, umfassend (A) eine polyfunktionelle Benzoxazinverbindung mit mindestens zwei Benzoxazinringen, (B) eine polyfunktionelle Epoxyverbindung mit mindestens einer Norbornanstruktur und mindestens zwei Epoxygruppen, (C) ein Härtungsmittel und (D) einen phosphorhaltigen Härtungsbeschleuniger, wobei die polyfunktionelle Benzoxazinverbindung von (A) eine erste Benzoxazinverbindung oder eine zweite Benzoxazinverbindung ist,
die erste Benzoxazinverbindung eine Verbindung mit mindestens zwei Benzoxazinringstrukturen ist, die durch die folgende Formel (1) wiedergegeben wird: 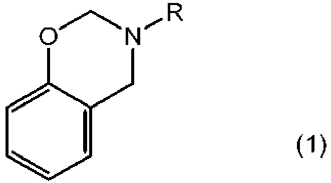
wobei R eine acyclische Alkylgruppe mit 1 bis 12 Kohlenstoffatomen, eine cyclische Alkylgruppe mit 3 bis 8 Kohlenstoffatomen oder eine Arylgruppe mit 6 bis 14 Kohlenstoffatomen ist, und die Arylgruppe einen Substituenten eines Halogenatoms oder einer acyclischen Alkylgruppe mit 1 bis 12 Kohlenstoffatomen aufweisen kann, wobei die Benzolringe in den beiden Benzoxazinringstrukturen aneinander gebunden sind, und
die zweite Benzoxazinverbindung durch die folgende Formel (2) wiedergegeben wird: 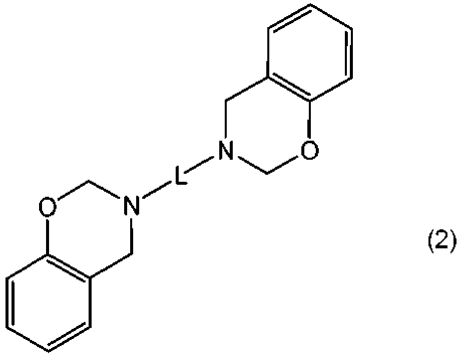
wobei L eine zweiwertige organische Gruppe mit 1 bis 5 aromatischen Ringen oder eine Alkylengruppe mit 2 bis 10 Kohlenstoffatomen ist, wobei die polyfunktionelle Epoxyverbindung (B) eine Verbindung mit einer 5-gliedrigen Ringstruktur, 6-gliedrigen Ringstruktur oder Norbornanringstruktur mit einer Epoxygruppe ist, die in den folgenden Formeln gezeigt sind:

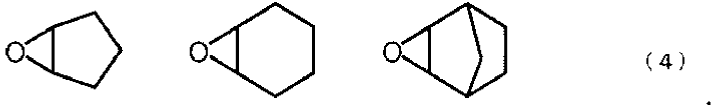

2. Härtbare Harzzusammensetzung nach Anspruch 1, wobei die polyfunktionelle Epoxyverbindung (B) ausgewählt ist aus den Verbindungen mit den folgenden Formeln:

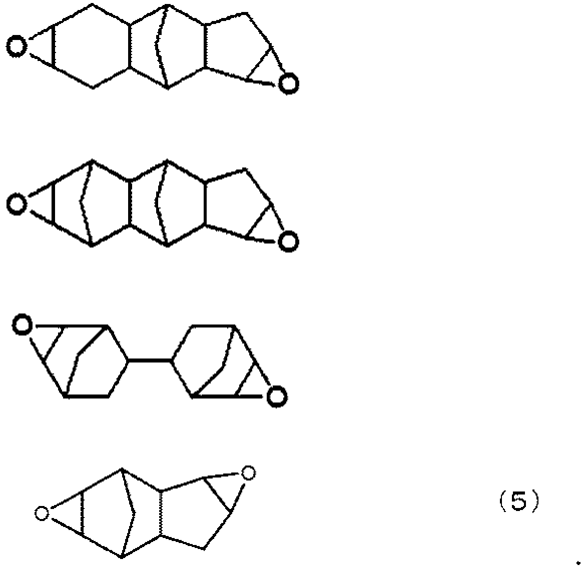

3. Härtbare Harzzusammensetzung nach einem der Ansprüche 1 bis 2, des Weiteren umfassend (E) einen anorganischen Füllstoff.

4. Härtbare Harzzusammensetzung nach einem der Ansprüche 1 bis 3, wobei das Härtungsmittel von (C) mindestens eines ausgewählt aus der Gruppe bestehend aus Imidazolverbindungen, aromatischen Aminverbindungen und polyfunktionellen Phenolverbindungen ist.

5. Gehärtetes Produkt, das durch Härten der härtbaren Harzzusammensetzung gemäß einem der Ansprüche 1 bis 4 erhalten wird.

6. Halbleitervorrichtung, umfassend ein gehärtetes Produkt, das erhalten wird, indem die härtbare Harzzusammensetzung gemäß Anspruch 3 gehärtet wird, und ein Halbleiterelement, das in dem gehärteten Produkt platziert ist.

7. Verfahren zum Härten einer härtbaren Harzzusammensetzung, umfassend die Schritte:
Erwärmen und Mischen (A) einer polyfunktionellen Benzoxazinverbindung mit mindestens zwei Benzoxazinringen, (B) einer polyfunktionellen Epoxyverbindung mit mindestens einer Norbornanstruktur und mindestens zwei Epoxygruppen, (C) eines Härtungsmittels, (D) eines phosphorhaltigen Härtungsbeschleunigers und (E) eines anorganischen Füllstoffs in einem Mischapparat, um eine Mischung zu erhalten;
Verarbeiten der Mischung zu einem Pulver, einem Pellet oder einem Granulum einer härtbaren Harzzusammensetzung; und
Erwärmen der härtbaren Harzzusammensetzung auf eine Temperatur von 180 °C bis 300 °C für einen Zeitraum von 20 Sekunden bis 1 Stunde, um die härtbare Harzzusammensetzung zu härten,
wobei die polyfunktionelle Benzoxazinverbindung von (A) eine erste Benzoxazinverbindung oder eine zweite Benzoxazinverbindung ist,
die erste Benzoxazinverbindung eine Verbindung mit mindestens zwei Benzoxazinringstrukturen ist, die durch die folgende Formel (1) wiedergegeben wird: 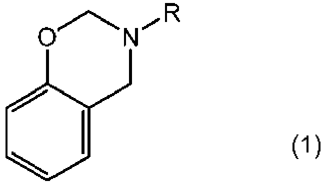
wobei R eine acyclische Alkylgruppe mit 1 bis 12 Kohlenstoffatomen, eine cyclische Alkylgruppe mit 3 bis 8 Kohlenstoffatomen oder eine Arylgruppe mit 6 bis 14 Kohlenstoffatomen ist, und die Arylgruppe einen Substituenten eines Halogenatoms oder einer acyclischen Alkylgruppe mit 1 bis 12 Kohlenstoffatomen aufweisen kann, wobei die Benzolringe in den beiden Benzoxazinringstrukturen aneinander gebunden sind, und
die zweite Benzoxazinverbindung durch die folgende Formel (2) wiedergegeben wird: 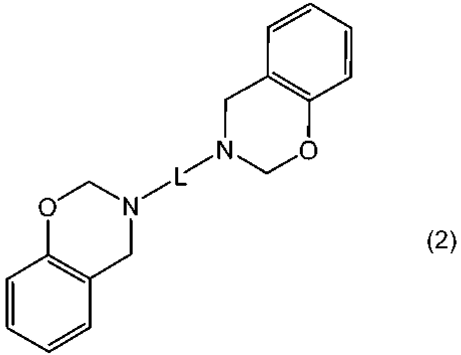
wobei L eine zweiwertige organische Gruppe mit 1 bis 5 aromatischen Ringen oder eine Alkylengruppe mit 2 bis 10 Kohlenstoffatomen ist, wobei die polyfunktionelle Epoxyverbindung (B) eine Verbindung mit einer 5-gliedrigen Ringstruktur, 6-gliedrigen Ringstruktur oder Norbornanringstruktur mit einer Epoxygruppe ist, die in den folgenden Formeln gezeigt sind:

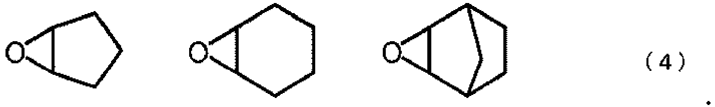

## Revendications

1. Composition de résine durcissable comprenant (A) un composé de benzoxazine polyfonctionnelle ayant au moins deux cycles benzoxazine, (B) un composé d'époxy polyfonctionnel ayant au moins une structure de norbornane et au moins deux groupes époxy, (C) un agent de durcissement et (D) un accélérateur de durcissement contenant du phosphore,
le composé de benzoxazine polyfonctionnelle de (A) étant un premier composé de benzoxazine ou un deuxième composé de benzoxazine,
le premier composé de benzoxazine étant un composé ayant au moins deux structures cycliques de benzoxazine représentées par la formule suivante (1) : 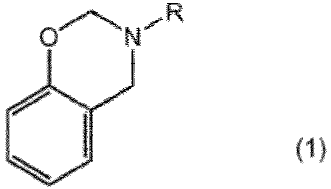
R étant un groupe alkyle acyclique ayant 1 à 12 atomes de carbone, un groupe alkyle cyclique ayant 3 à 8 atomes de carbone ou un groupe aryle ayant 6 à 14 atomes de carbone, et le groupe aryle pouvant avoir un substituant parmi un atome d'halogène ou un groupe alkyle acyclique ayant 1 à 12 atomes de carbone, les cycles benzéniques dans les deux structures cycliques de benzoxazine étant liés l'un à l'autre, et
le deuxième composé de benzoxazine étant représenté par la formule suivante (2) : 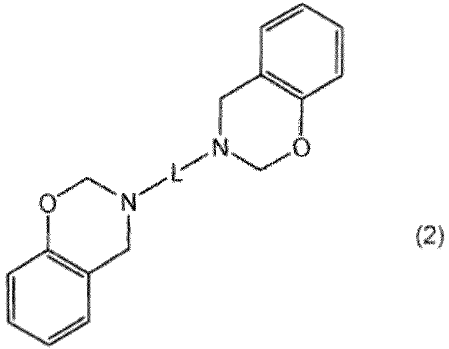
L étant un groupe organique divalent ayant 1 à 5 cycles aromatiques ou un groupe alkylène ayant 2 à 10 atomes de carbone, le composé d'époxy polyfonctionnel (B) étant un composé ayant une structure cyclique à 5 chaînons, une structure cyclique à 6 chaînons ou une structure cyclique de norbornane ayant un groupe époxy présentée dans les formules suivantes :

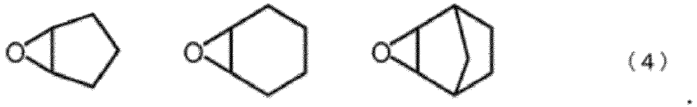

2. Composition de résine durcissable selon la revendication 1, le composé d'époxy polyfonctionnel (B) étant choisi parmi les composés des formules suivantes :

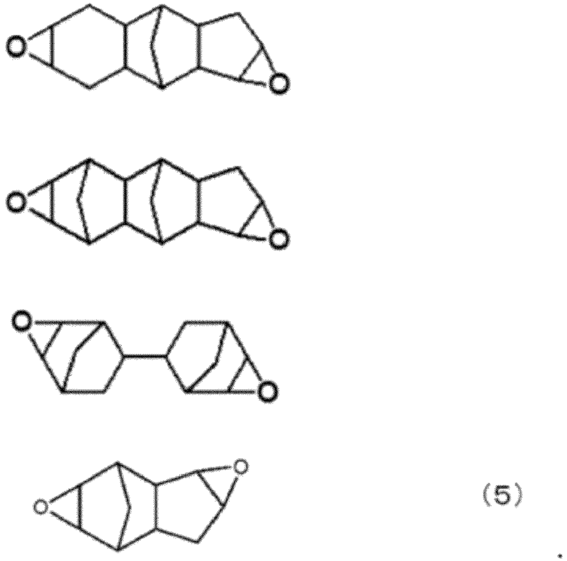

3. Composition de résine durcissable selon l'une quelconque des revendications 1 à 2, comprenant en outre (E) une charge inorganique.

4. Composition de résine durcissable selon l'une quelconque des revendications 1 à 3, l'agent de durcissement de (C) étant au moins l'un choisi dans le groupe constitué par des composés d'imidazole, des composés d'amine aromatique et des composés de phénol polyfonctionnel.

5. Produit durci obtenu par durcissement de la composition de résine durcissable selon l'une quelconque des revendications 1 à 4.

6. Dispositif semi-conducteur comprenant un produit durci obtenu par durcissement de la composition de résine durcissable selon la revendication 3 et un élément semi-conducteur placé dans le produit durci.

7. Procédé pour le durcissement d'une composition de résine durcissable comprenant les étapes de :
chauffage et mélange (A) d'un composé de benzoxazine polyfonctionnelle ayant au moins deux cycles benzoxazine, (B) d'un composé d'époxy polyfonctionnel ayant au moins une structure de norbornane et au moins deux groupes époxy, (C) d'un agent de durcissement, (D) d'un accélérateur de durcissement contenant du phosphore et (E) d'une charge inorganique dans un appareil de mélange pour obtenir un mélange ;
transformation du mélange en une poudre, une pastille ou un granulé d'une composition de résine durcissable ; et
chauffage de la composition de résine durcissable à une température de 180 °C à 300 °C pendant une période de 20 secondes à 1 heure pour durcir la composition de résine durcissable,
le composé de benzoxazine polyfonctionnelle de (A) étant un premier composé de benzoxazine ou un deuxième composé de benzoxazine,
le premier composé de benzoxazine étant un composé ayant au moins deux structures cycliques de benzoxazine représentées par la formule suivante (1) : 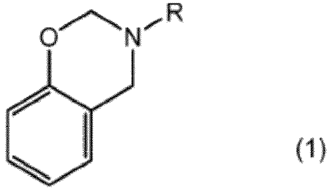
R étant un groupe alkyle acyclique ayant 1 à 12 atomes de carbone, un groupe alkyle cyclique ayant 3 à 8 atomes de carbone ou un groupe aryle ayant 6 à 14 atomes de carbone, et le groupe aryle pouvant avoir un substituant parmi un atome d'halogène ou un groupe alkyle acyclique ayant 1 à 12 atomes de carbone, les cycles benzéniques dans les deux structures cycliques de benzoxazine étant liés l'un à l'autre, et
le deuxième composé de benzoxazine étant représenté par la formule suivante (2) : 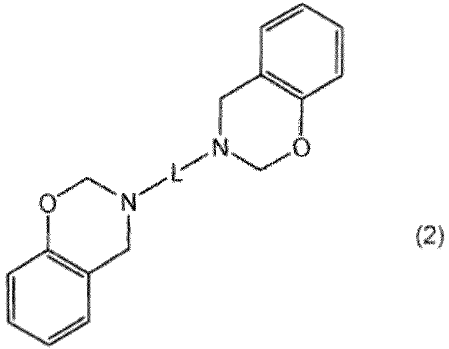
L étant un groupe organique divalent ayant 1 à 5 cycles aromatiques ou un groupe alkylène ayant 2 à 10 atomes de carbone, le composé d'époxy polyfonctionnel (B) étant un composé ayant une structure cyclique à 5 chaînons, une structure cyclique à 6 chaînons ou une structure cyclique de norbornane ayant un groupe époxy présentée dans les formules suivantes :
